# EUROPÄISCHE PATENTSCHRIFT

(11) **EP 1 154 278 B1**
(45) Veröffentlichungstag und Bekanntmachung des Hinweises auf die Patenterteilung: **20.10.2004**
(21) Anmeldenummer: 01810364.8
(22) Anmeldetag: 12.04.2001
(51) Int. Cl.: G01R 15/24

(54) **Faseroptischer Stromsensor**
Fibre-optic current sensor
Capteur de courant à fibre optique

(30) Priorität: 05.05.2000 DE 10021669
(43) Veröffentlichungstag der Anmeldung: 14.11.2001
(73) Patentinhaber: ABB RESEARCH LTD., 8050 Zürich (CH)
(72) Erfinder: Bohnert, Klaus, 5452 Oberrohrdorf (CH)
(74) Vertreter: ABB Patent Attorneys

(56) Entgegenhaltungen:
- WO-A-98/58268
- DE-A- 4 224 190
- US-A- 5 953 121
- DONATI S ET AL: "MAGNETO-OPTICAL FIBRE SENSORS FOR ELECTRICAL INDUSTRY: ANALYSIS OF PERFORMANCES" , IEE PROCEEDINGS J. OPTOELECTRONICS, INSTITUTION OF ELECTRICAL ENGINEERS. STEVENAGE, GB, VOL. 135, NR. 5, PART J, PAGE(S) 372-382 XP000027004 ISSN: 0267-3932 * Seite 372, linke Spalte, Absatz 1 * * Seite 376, linke Spalte, Zeile 52 - Seite 377, linke Spalte, Zeile 56; Abbildung 6 *

## Beschreibung

### Technisches Gebiet

Die Erfindung bezieht sich auf einen faseroptischen Stromsensor mit einem Reflexionsinterferometer gemäss Oberbegriff des Patentanspruches 1.

### Stand der Technik

Ein gattungsgemässer faseroptischer Stromsensor ist aus DE-A-4'224'190 und G. Frosio et al., "Reciprocal reflection interferometer for a fiber-optic Faraday current sensor", Applied Optics, Vol. 33, No. 25, Seite 6111-6122 (1994) bekannt. Er weist eine spulenförmig gewickelte, magneto-optisch aktive Sensorfaser auf, welche einen Stromleiter umschliesst. An einem Ende ist die Sensorfaser verspiegelt, am anderen Ende ist sie über ein Phasenverzögerungselement mit einer polarisationserhaltenden optischen Zuleitungsfaser verbunden, über welche sich Licht in die Sensorfaser ein- beziehungsweise auskoppeln lässt. Die Zuleitungsfaser propagiert dabei orthogonal linear polarisierte optische Wellen. Mit Hilfe von faseroptischen Phasenverzögerern werden diese vor Eintritt in die Sensorspule in zwei zirkular polarisierte Wellen umgewandelt, wobei die zwei zirkular polarisierten Wellen einen zueinander entgegengesetzten Drehsinn aufweisen. Nach Durchlaufen der Sensorspule werden die zwei zirkularen Wellen am Ende der Spule reflektiert, wobei sie mit vertauschtem Polarisationssinn durch die Spule zurücklaufen.

Fliesst nun ein Strom durch den Stromleiter, so bewirkt das magnetische Feld des Stroms eine differentielle Phasenverschiebung zwischen den beiden zirkularen optischen Wellen. Dieser Effekt wird magneto-optischer oder Faraday-Effekt genannt. Durch das zweimalige Durchlaufen der Spule akkumulieren die Wellen eine differentielle Phasenverschiebung von ΔΦ_{S} = 4 V N I, wobei V die Verdet-Konstante der Faser, N die Anzahl der Faserwindungen in der Spule und I den Strom durch den Stromleiter bezeichnet.

Die zirkularen Wellen werden beim Austritt aus der Spule in den Phasenverzögerern wieder in orthogonale linear polarisierte Wellen verwandelt und über die Zuleitungsfaser zu einem Detektionssystem geführt. Die durch den Strom verursachte Phasenverschiebung lässt sich detektieren, indem die zwei reflektierten linear polarisierten Wellen in einem an die Zuleitungsfaser anschliessenden Polarisator zur Interferenz gebracht werden.

Um eine grössere Auflösung bei der Detektion der differentiellen Phasenverschiebung zu erhalten, muss der effektive Arbeitspunkt des Interferometers in einem linearen Bereich seiner kosinusförmigen Interferenzfunktion liegen. Um dies zu erreichen, wird die differentielle Phase der beiden interferierenden linear polarisierten Wellen moduliert. Hierfür ist die Zuleitungsfaser mit einem Modulator wirkverbunden. Als Modulatoren wird im allgemeinen eine auf Resonanz betriebene, piezoelektrische Keramik eingesetzt, um welche einige Wicklungen der Zuleitungsfaser gewickelt sind. Der Modulator moduliert die Doppelbrechung der Faser und somit die differentielle Phase der beiden Wellen. Die Frequenz der Modulation liegt typischerweise im Bereich zwischen 100 kHz und einigen MHz und wird unter anderem durch die Länge der Faserverbindung zur Sensorfaser, das heisst der Zuleitungsfaser, bestimmt.

In der Praxis ist es jedoch schwierig, die differentielle Phase zweier orthogonaler optischer Wellen mit Hilfe einer piezoelektrischen Keramik mit ausreichend grosser Amplitude zu modulieren. Im Stand der Technik wird deshalb zu einer Kombination von Massnahmen gegriffen, um die erwünschte Amplitude zu erreichen. So wird im Bereich des Modulators die ansonsten im allgemeinen mit einem elliptischen Kern versehene Zuleitungsfaser durch einen Abschnitt einer empfindlicheren Faser mit stress-induzierter Doppelbrechung ersetzt. Es wird eine hohe Modulatorspannung verwendet und als piezoelektrische Keramik wird ein Hohlzylinder anstelle eines scheibenförmigen Elementes eingesetzt. Diese Massnahmen führen jedoch zu diversen Nachteilen: So weisen empfindlichere Fasern mit stress-induzierter Doppelbrechung eine grössere Temperaturabhängigkeit auf, sind auf dem Markt nicht stark verbreitet, sie sind teuer und lassen sich zudem teilweise schlecht mit anderen Fasertypen spleissen. Ferner stellt eine Faser mit stress-induzierter Doppelbrechung eine zusätzliche Komponente im Sensor dar, was die Komplexität des Aufbaus erhöht. Die hohe Modulatorspannung führt zu einer starken mechanischen Beanspruchung der Keramik und beeinträchtigt somit die Stabilität wie auch die Lebensdauer. Schliesslich weist die hohlzylinderförmige Keramik eine kleinere Resonanzfrequenz auf als die scheibenförmige, was in einer geringen nutzbaren Bandbreite des Sensors resultiert. Zudem muss eine längere Zuleitungsfaser verwendet werden, da die Länge der Modulationsfrequenz angepasst sein muss.

Aus G. Frosio et al., "All-fiber Sagnac Current Sensor", Proc. Opto 92, Seite 560-564 (1992) und EP-A-0'856'737 ist ein faseroptischer Stromsensor mit einem anderen Interferometer, einem sogenannten Sagnac-Interferometer, bekannt. Im Sagnac-Interferometer breiten sich in einem geschlossenen optischen Kreis zwei gegenläufige Lichtwellen aus. In der Sensorspule sind die beiden Wellen zirkular und in den beiden Verbindungsfasern zur Spule linear polarisiert. Die linearen Polarisationen sind dabei parallel zueinander ausgerichtet. Für die Modulation der differentiellen Phase zweier gegenläufiger Wellen mit paralleler Polarisation, ist eine im Vergleich zu orthogonal polarisierten Wellen 100 bis 1000fach geringere piezo-elektrische Deformation des Modulators notwendig, so dass die obengenannten Nachteile des Reflexionsinterferometers nicht vorhanden sind. Der Sensor mit dem Sagnac-Interferometer weist jedoch den Nachteil auf, dass er gegenüber mechanischen Erschütterungen anfällig ist. Dies ist u. a. eine Folge der endlichen Laufzeit der Wellen im optischen Kreis, da die beiden Wellen den Ort einer Störung zu unterschiedlichen Zeiten erreichen, und der inhärenten Empfindlichkeit des Sagnac-Interferometers auf Rotationsbewegungen.

Die Phasenmodulation der gegenläufigen Wellen im Sagnac-Stromsensor erfolgt völlig analog zur Modulation der gegenläufigen Wellen in einem Faserkreisel zur Messung von Drehgeschwindigkeiten, wie sie in H.C. Lefevre, "fiber-optic gyroscopes", Fiber-Optic Sensors, J. Dakin and B. Culshaw Editors, Vol. 2, Chapter 11, Artech House 1989, beschrieben ist.

### Darstellung der Erfindung

Es ist Aufgabe der Erfindung, einen faseroptischen Stromsensor mit einem Reflexionsinterferometer der eingangs genannten Art zu schaffen, welches auf einfache Art und Weise modulierbar ist.

Diese Aufgabe löst ein Stromsensor mit den Merkmalen des Patentanspruches 1.

Im erfindungsgemässen Stromsensor wird die differentielle Phase zweier gegenläufiger, parallel linear polarisierter Wellen moduliert. Um dies zu ermöglichen, weist ein Abschnitt einer faseroptischen Zuleitung des erfindungsgemässen Stromsensors zwei Faserzweige auf, wobei die zwei Faserzweige zwei Faserkoppler miteinander verbinden. In den beiden Faserzweigen breiten sich linear polarisierte Wellen aus, die in einem der Koppler in orthogonale Polarisationen übergeführt werden, bevor sie zum spulenförmigen optischen Sensorelement gelangen. Die von der Sensorspule zurückkehrenden orthogonalen Polarisationen werden im zweiten Koppler wieder auf die beiden Faserzweige aufgeteilt und im ersten Koppler wieder vereinigt. Es sind Mittel vorhanden, um die Polarisationsrichtung bezüglich der Faserachsen in einem der Faserzweige zu ändern. Die Modulation erfolgt in einem oder beiden der Faserzweige.

Da die Trennung der faseroptischen Zuleitung lediglich über eine kurze Distanz erfolgt, findet praktisch keine Beeinflussung des Signals durch mechanische Erschütterungen statt.

In den zwei Faserzweigen lassen sich Wellen mit linearer Polarisation parallel zur langen und kurzen Achse des Faserkerns propagieren. Vorzugsweise verfügen jedoch mindestens eine, in einer ausgewählten Ausführungsform sogar beide Faserzweige über einen Polarisator, so dass im Faserzweig nur eine einzige Polarisationsrichtung vorhanden ist.

Das Mittel zur Änderung der Polarisationsrichtung bezüglich der Achsen des Faserkerns ist vorzugsweise ein 90°-Spleiss, der in einen der zwei Faserzweige zwei Fasersegmente verbindet.

In einer bevorzugten Ausführungsform ist ein Detektor und eine Lichtquelle mit demselben Fasersegment eines Faserkopplers verbunden. Diese Anordnung ist insbesondere zur Messung von Gleichströmen geeignet.

Der erfindungsgemässe Stromsensor lässt sich auf einfache Art und Weise multiplexen, indem mehrere spulenförmige Sensorfasern von derselben faseroptischen Zuleitung versorgt werden. Hierfür verfügt die faseroptische Zuleitung über eine entsprechende Anzahl von weiteren Faserzweigen, welche in Serie mit den ersten zwei Faserzweigen angeordnet sind.

Weitere vorteilhafte Ausführungsformen gehen aus den abhängigen Patentansprüchen hervor.

### Kurze Beschreibung der Zeichnungen

Im folgenden wird der Erfindungsgegenstand anhand von bevorzugten Ausführungsbeispielen, welche in den beiliegenden Zeichnungen dargestellt sind, näher erläutert. Es zeigen:
- Figur 1: eine schematische Darstellung eines erfindungsgemässen Stromsensors in einer ersten Ausführungsform;
- Figur 2: einen erfindungsgemässen Stromsensor in einer zweiten Ausführungsform;
- Figur 3: einen erfindungsgemässen Stromsensor in einer dritten Ausführungsform;
- Figur 4: einen erfindungsgemässen Stromsensor in einer vierten Ausführungsform;
- Figur 5: einen erfindungsgemässen Stromsensor in einer fünften Ausführungsform und
- Figur 6: einen erfindungsgemässen Stromsensor in einer sechsten Ausführungsform.

### Wege zur Ausführung der Erfindung

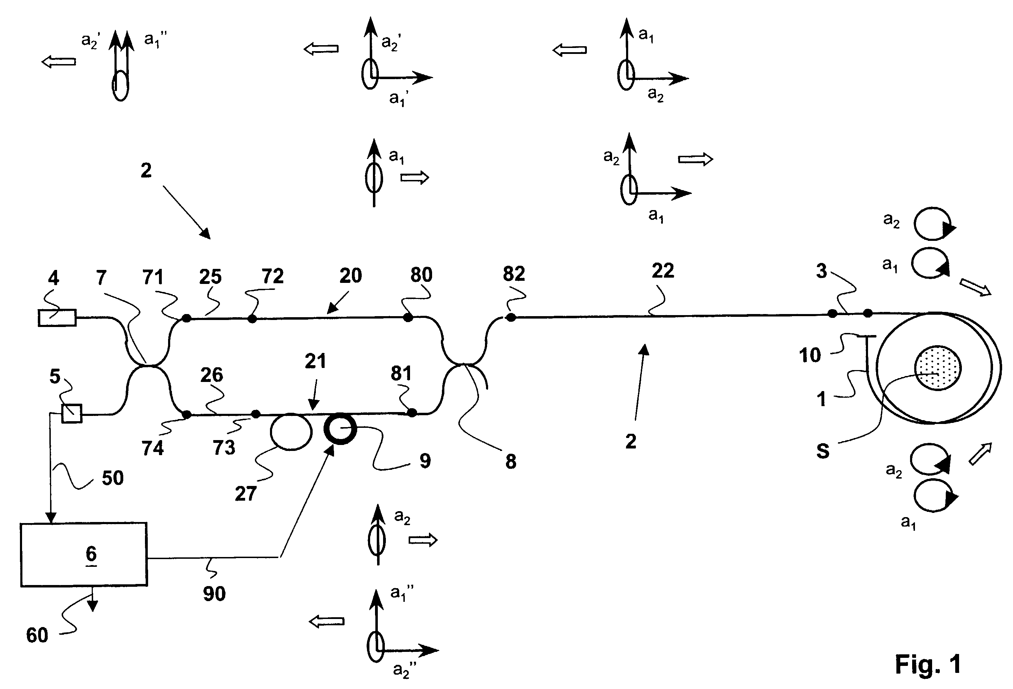

Figur 1 zeigt einen faseroptischen Stromsensor mit einem Reflexionsinterferometer. Eine Sensorfaser 1 ist spulenförmig um einen Stromleiter S gewickelt. Sie weist vorzugsweise einen runden Kernquerschnitt auf und ist vorzugsweise aus Quarzglas gefertigt. Ein erstes Ende der Sensorfaser 1 ist mit einer faseroptischen Zuleitung 2 verbunden. Ein zweites Ende ist mit einem Reflektor 10 versehen. Im allgemeinen ist der Reflektor 10 durch eine Verspiegelung des zweiten Faserendes gebildet. Die faseroptische Zuleitung 2 besteht im wesentlichen und bis auf die Ausnahme der erfindungsgemässen Aufteilung der Zuleitung, aus einer doppelbrechenden optischen Faser, welche mindestens abschnittsweise polarisationserhaltend ausgebildet. Vorzugsweise weist sie zur Erzeugung der Doppelbrechung einen elliptischen Kernquerschnitt auf. Die Verwendung einer stress-induzierten doppelbrechenden Faser ist jedoch möglich. Die Verbindung der faseroptischen Zuleitung 2 mit der Sensorfaser 1 erfolgt über ein Phasenverzögerungselement 3, wobei hierfür vorzugsweise ein λ/4 Phasenverzögerungs-Fasersegment eingesetzt ist.

Ferner ist eine Lichtquelle 4 vorhanden, deren Licht durch die Fasern übermittelt wird. Als Lichtquelle eignen sich insbesondere solche mit einer kleinen Kohärenzlänge, insbesondere eine Superlumineszenzdiode, eine unter der Laserschwelle betriebene Laserdiode, eine LED oder eine breitbandige Faserlichtquelle. Der Sensor verfügt über einen Detektor 5, insbesondere eine Photodiode, welche durch die Sensorfaser und die faseroptische Zuleitung propagiertes und zur Interferenz gebrachtes Licht detektiert. Dieser Detektor 5 ist über eine Detektorsignalleitung 50 mit einem Signalprozessor 6 verbunden, welcher das Sensorsignal über eine Sensorsignalleitung 60 an eine nicht dargestellte Auswerteelektronik übermittelt.

Erfindungsgemäss trennt sich die faseroptische Zuleitung 2 während einer bestimmten Strecke in zwei Faserzweige 20,21 auf, welche somit parallel geschaltet sind. Die Faserzweige 20,21 verbinden einen detektionsseitigen und einen sensorseitigen polarisationserhaltenden Koppler 7,8 miteinander. Im hier dargestellten bevorzugten Ausführungsbeispiel sind diese zwei Koppler 7,8 Faserkoppler mit einem elliptischen Kern. Es ist jedoch auch möglich, andere Arten von Kopplern zu verwenden. Ferner sind in beiden Faserzweigen 20,21 Polarisatoren 25,26 vorhanden, wobei diese so gerichtet sind, dass ihre Polarisationsrichtungen parallel zu einer der Hauptachsen der Zweige 20, 21 liegen. Vorzugsweise sind sie parallel zur langen oder langsamen Hauptachse des Kerns des Faserzweiges 20,21 gerichtet.
Es ist jedoch auch möglich, sie parallel zur kurzen oder schnellen Hauptachse zu richten oder je eine zur langen und zur kurzen Achse auszurichten.

In diesem Beispiel sind Faserpolarisatoren eingesetzt, die Verwendung anderer Polarisatoren ist jedoch möglich. Die Faserzweige 20,21 sind detektorseitig über Spleisse 72,73 mit den Polarisatoren 25,26 und diese über Spleisse 71,74 mit dem detektorseitigen Kopplern 7 verbunden. Sensorseitig sind die Faserzweige 20,21 ebenfalls über Spleisse 80, 81 mit dem sensorseitigen Koppler 8 verbunden. Desgleichen ist ein sensorseitiges Segment 22 der faseroptischen Zuleitung 2 über einen Spleiss 82 mit dem Koppler 8 verbunden.

Einer der zwei Faserzweige 20,21 weist ferner vorzugsweise ein Verzögerungselement, hier in Form einer Faserschlaufe 27, auf. Ebenfalls an einem der zwei Faserzweige 20,21 ist ein Phasenmodulator 9 vorhanden, welcher über eine Modulationssignalleitung 90 mit dem Signalprozessor 6 verbunden ist. Im hier dargestellten Ausführungsbeispiel sind sowohl Phasenmodulator 9 wie auch Verzögerungselement 27 auf demselben Faserzweig 21 angeordnet. Als Phasenmodulator 9 ist vorzugsweise ein piezo-elektrischer Modulator eingesetzt, wobei ein Teil des Faserzweigs 21 um einen piezo-elektrischen Körper des Modulators gewickelt ist. Es ist jedoch auch möglich, andere Modulatoren einzusetzen, insbesondere einen integriert-optischen Modulator, welcher auf dem elektro-optischen Effekt in einem Wellenleiter basiert.

In Figur 1 sind die einzelnen Polarisationsrichtungen bezüglich der Achsen des Faserkerns der in den Fasern propagierenden Wellen mit schmalen Pfeilen dargestellt. Zudem geben breite Pfeile die Ausbreitungsrichtung der Wellen an. Licht, welches von der Lichtquelle 4 emittiert wird, wird im detektorseitigen Faserkoppler 7 auf die zwei Faserzweige 20,21 der faseroptischen Zuleitung 2 in eine erste und eine zweite Welle a₁, a₂ aufgeteilt. Das Teilungsverhältnis ist dabei vorzugsweise 1:1. In den beiden faseroptischen Polarisatoren 25,26 wird das Licht linear polarisiert und propagiert dann durch den restlichen polarisationserhaltenden Faserzweig 20,21 zum sensorseitigen Koppler 8. Die in den Faserzweigen 20,21 sich in Richtung Sensorfaser 1 ausbreitenden optischen Wellen weisen dabei Polarisationsrichtungen auf, welche in diesem Beispiel parallel zur grossen Hauptachse des Faserkerns ausgerichtet sind. Die entsprechenden Pfeile sind in Figur 1 mit a₁ und a₂ bezeichnet.

Die Wellen werden nun so in die zwei Eingänge des sensorseitigen Kopplers 8 eingekoppelt, dass ihre Polarisationen nach dem Verlassen des Kopplers, d. h. im Segment 22 der faseroptiscnen Zuleitung 2 orthogonal zueinander ausgerichtet sind. Dazu wird eine Welle mit der Polarisation parallel zur langen und die andere parallel zur kleinen Achse der Kopplereingänge eingekoppelt. Hierfür ist zwischen einem Faserzweig, hier dem ersten Faserzweig 20, und einem Koppler, hier dem sensorseitigen Koppler 8, ein Mittel vorhanden, um die Polarisationsrichtung bezüglich der Faserachsen zu verändern. Licht, das vor Durchlaufen dieses Mittels parallel zur langen Achse schwingt, schwingt nach dem Durchlaufen parallel zur kurzen Achse, und Licht, das vor Durchlaufen dieses Mittels parallel zur kurzen Achse schwingt, schwingt nach dem Durchlaufen parallel zur langen Achse.

Im Beispiel gemäss Figur 1 ist dieses Mittel der Spleiss 80 zwischen Faserzweig 20 und Faserkoppler 8, welcher als 90°-Spleiss ausgebildet ist. Das heisst, die Fasern des ersten Faserzweigs 20 und des Faserkopplers 8 sind am Spleiss 80 so zusammengefügt, dass die langen Hauptachsen ihrer Kerne mindestens annähernd orthogonal ausgerichtet sind. Der Spleiss 81 hingegen, welcher den zweiten Faserzweig 21 mit dem Faserkoppler 8 zusammenfügt, ist ein 0°-Spleiss, das heisst, die langen Hauptachsen der Kerne der Fasern sind mindestens annähernd parallel zueinander ausgerichtet. In dem dem Koppler 8 anschliessenden sensorseitigen Segment 22 der faseroptischen Zuleitung 2 laufen dann zwei Wellen mit orthogonalen linearen Polarisationen. Dies ist in Figur 1 ebenfalls mit Pfeilen dargestellt. Beim anschliessenden Durchlaufen des faseroptischen λ/4-Verzögererelementes werden sie in links- und rechtszirkulare Wellen verwandelt, wie in Figur 1 sichtbar ist. Die zirkularen Wellen durchlaufen die Sensorfaser 1, werden am Spulenende 10 reflektiert, vertauschen dabei ihre Polarisationszustände, laufen durch die Spule zurück und werden im λ/4-Verzögerer wieder in orthogonale lineare Wellen verwandelt, deren Polarisation jetzt senkrecht zur Polarisation der entsprechenden Wellen der Vorwärtsrichtung steht.

Im sensorseitigen Koppler 8 wird jede der beiden orthogonalen Wellen auf die beiden Faserzweige 20,21 aufgeteilt, wobei sich die erste Welle a₁ in die zurücklaufenden Wellen a₁' und a₁" aufteilt und die zweite Welle a₂ in zurücklaufende Wellen a₂' und a₂". Dabei schwingen die zurücklaufenden Wellen a₁" und a₂' in den beiden Faserzweigen 20,21 parallel zu den vorwärts laufenden Wellen a₁ und a₂. Diese zurücklaufenden Wellen a₁" und a₂' sind aus Wellen entstanden, welche in ihrer Vorwärtsausbreitung sich im jeweils anderen Faserzweig bewegt haben. Die zurücklaufenden Wellen a₁' und a₂", welche in den beiden Faserzweigen 20,21 orthogonal zu den vorwärts laufenden Wellen a₁ und a₂ schwingen, sind aus Wellen entstanden, welche sich bei ihrer Vorwärtsausbreitung im jeweils gleichen Faserzweig bewegt haben. Die zurücklaufenden Wellen a₁" und a₂' können die Faserpolarisatoren 25,26 passieren, werden im detektionsseitigen Koppler 7 zur Interferenz gebracht und werden schliesslich im Detektor 5 detektiert. Die dazu orthogonalen Wellen a₁' und a₂" werden in den Polarisatoren 25,26 blockiert.

Die beiden Faserzweige 20,21 weisen vorzugsweise einen optischen Längenunterschied ΔL auf, was in den hier beschriebenen Beispielen durch das Verzögerungselement 27 und/oder durch den den Piezokristall umschlingenden Teil des Fasersegmentes erreicht wird. Dieser optische Längenunterschied ΔL ist dabei grösser als die Kohärenzlänge der Lichtquelle 4. Falls die rücklaufenden Wellen a₁' und a₂" in den Polarisatoren 25,26 nicht vollständig ausgelöscht werden, so können sie aufgrund ihres Gangunterschiedes von insgesamt 2ΔL im detektionsseitigen Koppler 7 nicht interferieren und damit keinen störenden Beitrag zum Messignal liefern. Durch Wahl einer Lichtquelle mit kleiner Kohärenzlänge lässt sich auch die Verzögerungsstrecke minimieren.

Die am detektionsseitigen Koppler 7 interferierenden Wellen a₁" und a₂' haben im stromlosen Fall einen Phasenunterschied Δφ von Null. Der Arbeitspunkt des Interferometers liegt dann in einem Maximum der kosinusförmigen Interferenzfunktion. Die Empfindlichkeit des Interferometers ist hier sehr klein. Der Phasenmodulator moduliert nun die differentielle Phase der interferierenden Wellen, das heisst a₁" und a₂', analog zu einem Faserkreisel, welche in der Beschreibungseinleitung erwähnt worden ist. Es handelt sich dabei um eine dynamische Phasenmodulation, bei welche eine nicht-reziproke Phasenmodulation durch Modulation von gegenläufigen Wellen erreicht wird. Der effektive Arbeitspunkt wird so gewählt, dass er im linearen Bereich der Kosinusfunktion liegt. Vorzugsweise werden die Schwingungsfrequenz und -amplitude des Phasenmodulators so gewählt, dass die Amplidude ηₒ der differentiellen Phasenmodulation 1.84 rad beträgt und damit der Position des Maximums der Besselfunktion erster Ordnung entspricht.

Die Faserzweige 20, 21 mit den Kopplern 7, 8 bilden einen optischen Kreisel, das heisst, eine Drehung der Anordnung führt ebenfalls zu einer differentiellen Phasenverschiebung zwischen den interferierenden Wellen a₁" und a₂'. Die Phasenverschiebung ist umso grösser, je grösser die von den beiden Zweigen 20, 21 umschlossene Fläche ist. Um solche störenden Signale zu vermeiden, werden die Faserzweige 20,21 vorzugsweise so verlegt, dass die von ihnen umschlossene Fläche möglichst klein, im Idealfall gleich Null ist.
Der gleiche Effekt tritt auch in den Faserwindungen auf, die auf den Piezomodulator 9 aufgewickelt sind bzw. in der Verzögerungsschlaufe 27. In diesem Fall kann man rotationsbedingte Phasenverschiebungen kompensieren, indem zum Ausgleich eine Segment der Faserzweige 20 oder 21 mit umgekehrtem Drehsinn aufwickelt. Die Anzahl der Windungen und die eingeschlossene Fläche werden so gewählt, dass eine möglichst vollständige Kompensation erreicht wird.

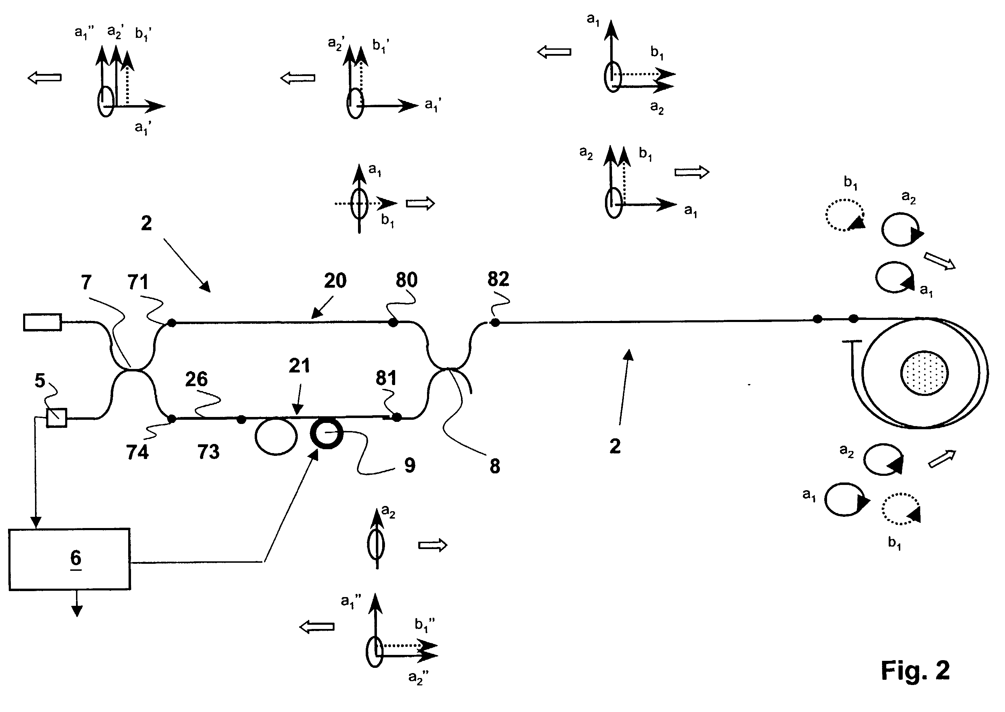

In Figur 2 ist ein zweites Ausführungsbeispiel des erfindungsgemässen Stromsensors dargestellt. Der Aufbau ist im wesentlichen derselbe wie im vorherigen Beispiel, es ist jedoch nur in einem hier im zweiten Faserzweig 21 ein Faserpolarisator 26 vorhanden. Dadurch propagiert im ersten Faserzweig 20 eine dritte Welle b₁, wie dies in der Figur anhand der Polarisationsrichtungen der Wellen erkennbar ist.
Es erreichen nun vier rücklaufende Wellen, nämlich a₁", a₂', b₁' und a₁' den Detektor. Dabei sind die Wellen a₁" und a₂' kohärent. Aus ihrer Interferenz wird wiederum das Sensorsignal gewonnen. Die rücklaufende dritte Welle b₁' hat bezüglich a₁" und a₂' einen Gangunterschied von ΔL und interferiert deshalb nicht mit a₁" und a₂', sondern liefert lediglich einen konstanten Intensitätsuntergrund. Die rücklaufende erste Welle a₁' hat zwar keinen Wegunterschied im Vergleich zu b₁', liefert aber wegen ihrer orthogonalen Polarisation ebenfalls nur einen phasenunabhängigen Intensitätsuntergrund.

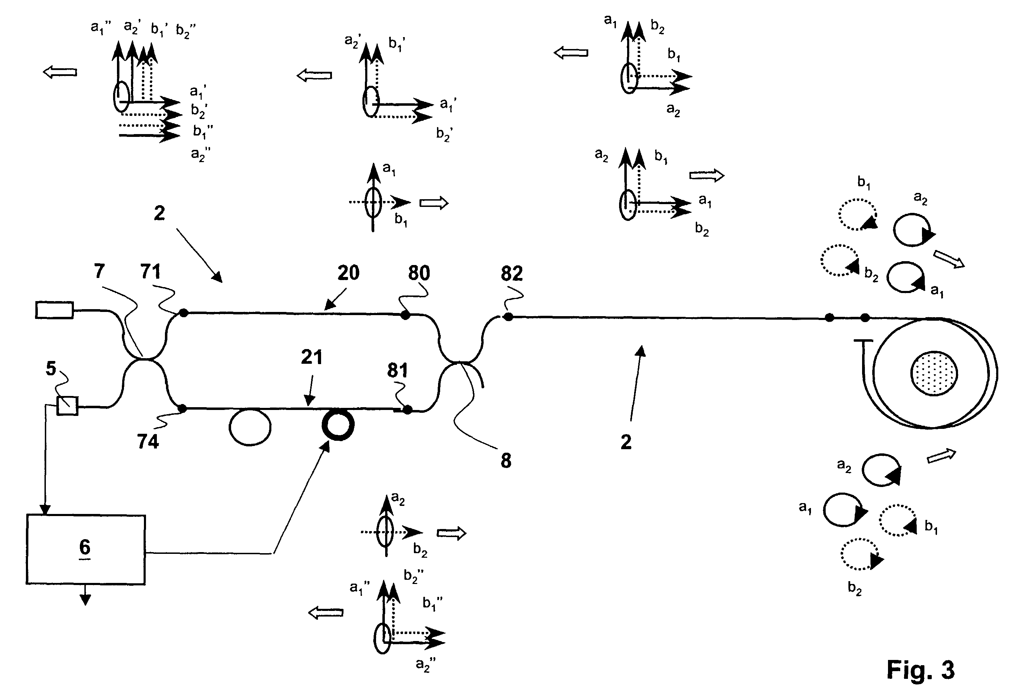

In Figur 3 ist ein drittes Ausführungsbeispiel dargestellt, welches gar keine Polarisatoren in den Faserzweigen 20,21 aufweist, so dass eine vierte Welle b₂ vorhanden ist. In den Faserzweigen 20,21 werden beide Polarisationen angeregt und zur Sensorfaser 1 gesendet, so dass insgesamt acht rücklaufende Wellen a₁", a₂', b₁', b₂", a₁', b₂', b₁", a₂" am Detektor 5 eintreffen. Jeweils vier Wellen a₁", a₂', b₁', b₂" sind parallel zur langen und vier Wellen a₁', b₂', b₁", a₂" zur kurzen Hauptachse des Faserkerns. Die beiden Wellen a₁" und a₂' mit der Polarisation parallel zur langen Achse sind kohärent. Aus ihrer Interferenz ergibt sich ein Sensorsignal. Die Wellen b₂" und b₁' haben bezüglich a₁" und a₂' Gangunterschiede von + ΔL bzw. von - ΔL und liefern deshalb keinen Signalbeitrag. Der Modulator 9 hat zudem ihre differentielle Phase nicht oder nur mit sehr kleiner Amplitude moduliert. Die beiden Wellen b₁" und b₂' mit der Polarisation parallel zur kurzen Achse sind ebenfalls kohärent. Aus ihrer Interferenz ergibt sich damit ebenfalls ein Signalbeitrag. Die Wellen a₂" und a₁' haben bezüglich b₁" und b₂' wieder Gangunterschiede von + ΔL bzw. von - ΔL und liefern deshalb keinen Signalbeitrag. Die relativen Signalbeiträge von a₁" und a₂' bzw. von b₁" und b₂' sind in der Regel unterschiedlich, da der Modulator 9 die differentielle Phase der beiden Wellenpaare aufgrund ihrer unterschiedlichen Polarisationsrichtung mit unterschiedlicher Amplitude moduliert. Falls erwünscht, können die Wellen einer der beiden Polarisationsrichtungen vor dem Detektor mit einem, hier nicht dargestellten, Polarisator blockiert werden.

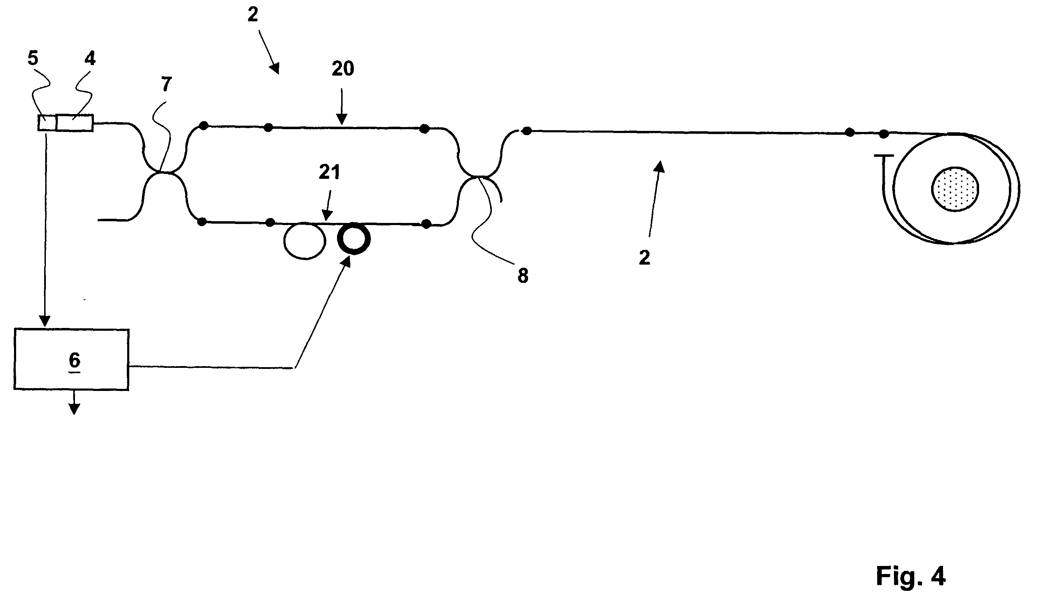

In den bisher beschriebenen Ausführungsformen ist der Detektor 5 an einem von der Lichtquelle 4 getrennten Faserende des detektionsseitigen Faserkopplers 7 angeordnet. Es ist jedoch auch, wie in Figur 4 dargestellt, möglich, die zurückkehrenden, interferierenden Wellen an einem mit der Lichtquelle 4 verbundenen Eingangsarm des Kopplers 1 zu detektieren. In diesem Falle ist der Detektor 5 hinter der Lichtquelle 4 und somit an demselben Ein-bzw. Ausgang des Kopplers 7 angeordnet. Diese Anordnung ist für alle bisher beschriebenen Ausführungsformen möglich.
Bei dieser Anordung wird der detektionsseitige Koppler 7 in reziproker Weise von den vorwärtslaufenden wie auch von den rücklaufenden Wellen durchlaufen, d. h. wenn man den Koppler analog zu einem Strahlteiler betrachtet, wird jede Welle am Koppler einmal reflektiert und einmal transmittiert. Die gesamte differentielle Phasenverschiebung der Wellen am detektionsseitigen Koppler 7 ist damit exakt Null. Bei den Ausführungsformen gemäss den Figuren 1 bis 3 durchlaufen die Wellen den detektionsseitigen Koppler 7 dagegen in nicht-reziproker Weise. Eine Welle wird zweimal reflektiert, die andere zweimal transmittiert. Daraus kann sich eine differentielle Phasenverschiebung ergeben, die nicht von der Phasenverschiebung, welche ein Gleichstrom erzeugt, unterschieden werden kann. Die Ausführungsform gemäss Figur 4 ist deshalb insbesondere zur Messung von Gleichströmen geeignet.

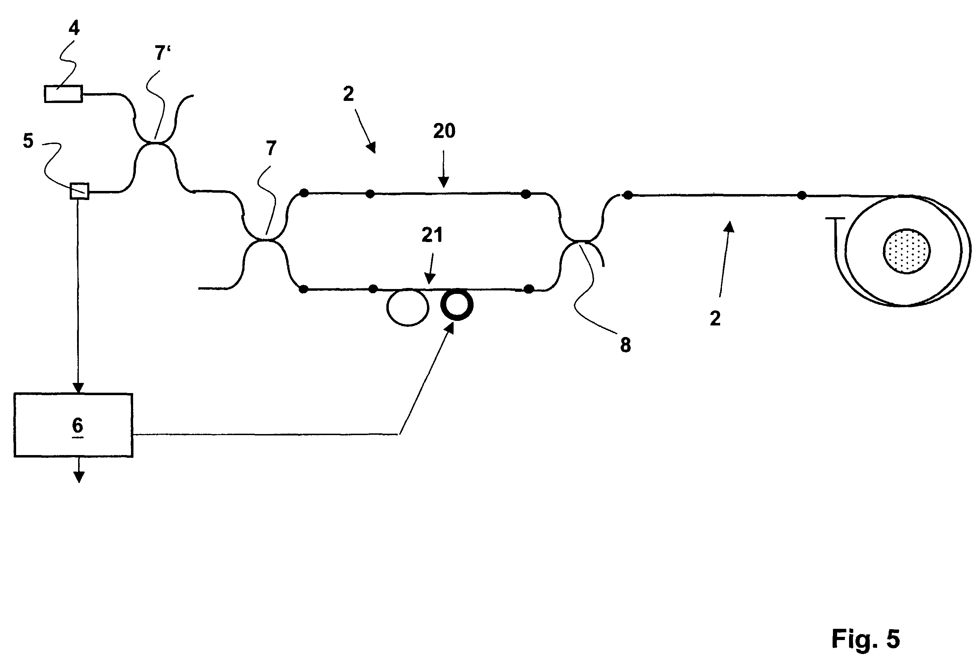

Figur 5 zeigt in einem fünften Ausführungsbeispiel eine Modifikation des vierten. Hier ist zwischen der Lichtquelle 4 und dem detektionsseitigen Koppler 7 ein dritter Koppler 7', vorzugsweise ebenfalls ein Faserkoppler, angeordnet. Diese Konfiguration erlaubt wiederum reziproke optische Wege für die beiden interferierenden Wellen. Wie in den Ausführungsbeispielen gemäss den Figuren 1 bis 3 werden die Wellen jedoch mit einem von der Lichtquelle 4 getrennten Detektor 5 detektiert. Ein Vorteil im Vergleich zum vierten Ausführungsbeispiel besteht darin, dass der Detektor 5 nicht dem direkten Laserlicht ausgesetzt ist. Der eher störende Gleichstromuntergrund im Photodiodensignal ist damit wesentlich niedriger.

Weitere Varianten der obengenannten Ausführungsbeispiele sind möglich. So lassen sich Modulator, Verzögerungsschlaufe und Polarisatoren beliebig auf den zwei Faserzweigen verteilen. Das Mittel zur Veränderung der Polarisation lässt sich auch an anderen Stellen anordnen. So lässt sich anstelle des anhand der Figur 1 beschriebenen Spleisses 80 auch einer der anderen dargestellten Spleisse 71, 72, 26, 73, 81 als 90° Spleiss gestalten. Es können auch mehrere der Spleisse als 90°-Spleiss ausgeführt sein. Ihre Zahl muss nur ungerade sein.
Ferner lassen sich in beiden Faserzweigen Phasenmodulatoren einsetzen. Dies hat den Vorteil, dass nochmals eine Verringerung der notwendigen Modulationsstärke erzielt wird.
Ferner lässt sich anstelle einer spulenförmigen Sensorfaser ein spulenförmiges integriert optisches Sensorelement einsetzen. Die Spule kann in beiden Fällen aus lediglich einer einzigen Windung bestehen.

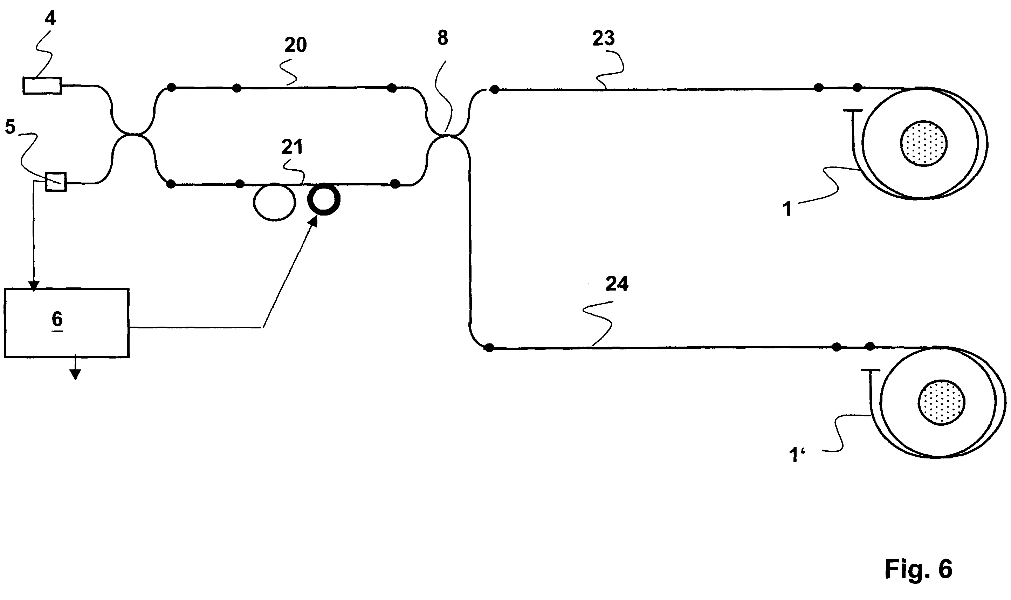

In Figur 6 ist in einem sechsten Ausführungsbeispiel ein Multiplexing des Sensors dargestellt. Es sind mehrere, hier zwei spulenförmige Sensorfaser 1,1' vorhanden, welche mit derselben faseroptischen Zuleitung 2 verbunden sind. Die Zuleitungsfaser 2 weist hierfür eine entsprechende Anzahl, hier zwei, weitere Faserzweige 23,24 auf, welche in Serie mit den zwei ersten Faserzweigen 20,21 angeordnet sind. Hier ist ein dritter Faserzweig 23 mit einem ersten Ausgang des sensorseitigen Faserkopplers 8 und ein vierter Faserzweig 24 mit einem zweiten Ausgang verbunden. Somit ist jede Sensorfaser 1,1' mit einem zusätzlichen Faserzweig 23,24 verbunden. Die zusätzlichen Faserzweige 23,24 haben unterschiedliche Längen, so dass die Signale der beiden Sensorfasern 1,1' aufgrund der verschiedenen Laufzeiten der entsprechenden optischen Wellen unterschieden werden können. Um ein solches Zeitmultiplexing zu ermöglichen, ist die Emission der Lichtquelle 4 entweder gepulst oder frequenzmoduliert, wobei im zweiten Fall die Modulationsfrequenz als Funktion der Zeit beispielsweise sägezahnartig verändert wird.
Die beiden Sensorfasern 1,1' sind vorzugsweise mit einer unterschiedlicher Zahl von Faserwindungen ausgestattet. Die Sensorfaser mit wenigen Windungen lässt sich dann vorzugsweise für Messung hoher Ströme bei Kurzschlüssen einsetzen, so dass sie eine Schutzfunktion übernimmt. Die andere Sensorfaser mit der grösseren Windungszahl lässt sich zur genauen Messung der relativ kleinen Ströme im Normalbetrieb verwenden.

Der erfindungsgemässe Stromsensor kombiniert die Vorteile eines Reflexionsinterferometers mit denjenigen eines Sagnac-Interferometers, indem zwar lediglich eine einzige Faser als Zu- und Rückleitungsfaser dient, diese jedoch über eine kurze Strecke zwei Zweige aufweist und somit die Verwendung von parallel linear polarisierten Wellen ermöglicht.

### Bezugszeichenliste

- S: Stromleiter

- a₁: erste optische Welle
- a'₁: rücklaufende erste optische Welle
- a₂: zweite optische Welle
- a'₂: zurücklaufende zweite optische Welle
- b₁: dritte optische Welle
- b'₁: zurücklaufende dritte optische Welle
- b₂: vierte optische Welle
- b'₂: zurücklaufende vierte optische Welle

- 1: Sensorfaser
- 10: Reflektor
- 2: Zuleitungsfaser
- 20: erster Faserzweig
- 21: zweiter Faserzweig
- 22: sensorseitiges Segment
- 23: dritter Faserzweig
- 24: vierter Faserzweig
- 25: Faserpolarisator
- 26: Faserpolarisator
- 27: Verzögerungsschlaufe
- 3: Phasenverzögerungselement
- 4: Lichtquelle
- 5: Detektor
- 50: Detektorsignalleitung
- 6: Signalprozessor
- 60: Sensorsignalleitung
- 7: detektorseitiger Faserkoppler
- 71,72,73,74: Spleiss
- 7': dritter Koppler
- 8: sensorseitiger Faserkoppler
- 80,81,82: Spleiss
- 9: Phasenmodulator
- 90: Modulationssignalleitung

## Patentansprüche

1. Optischer Stromsensor
mit einem Reflexionsinterferometer, welches eine faseroptische Zuleitung (2) und ein spulenförmiges optisches Sensorelement (1) aufweist, wobei das Sensorelement (1) mit einem ersten Ende mit der faseroptischen Zuleitung (2) verbunden und an einem zweiten, freien Ende mit einem Reflektor (10) versehen ist,
mit mindestens einem Phasenmodulator (9) zur Modulation von differentiellen Phasen zweier in der faseroptischen Zuleitung (2) propagierender polarisierter Wellen und einem Detektor (5),
**dadurch gekennzeichnet,**
**dass** die faseroptische Zuleitung (2) zwei Faserzweige (20,21) aufweist, welche einen detektorseitigen und einen sensorseitigen Koppler (7,8) miteinander verbinden, dass der mindestens eine Phasenmodulator (9) in einem dieser zwei Faserzweige (20,21) angeordnet ist,
wobei er die differentielle Phase zweier gegenläufiger parallel zueinander polarisierter Wellen moduliert, und dass ein Faserzweig (20) mit einem Mittel zur Änderung der Polarisationsrichtung (80) versehen ist, so dass in einem dem sensorseitigen Koppler (8) anschliessenden Segment (22) der Zuleitungsfaser (2) optische Wellen mit orthogonal linearen Polarisationen propagieren.

2. Stromsensor nach Anspruch 1, **dadurch gekennzeichnet, dass** mindestens ein Faserzweig (20,21) einen Polarisator (25,26) zur Erzeugung einer linearen polarisierten optischen Welle aufweist.

3. Stromsensor nach Anspruch 2, **dadurch gekennzeichnet, dass** beide Faserzweige (20,21) einen Polarisator (25,26) aufweisen zur Erzeugung von optischen Wellen mit parallel zueinander gerichteten linearen Polarisationen.

4. Stromsensor nach Anspruch 1, **dadurch gekennzeichnet, dass** das Mittel zur Änderung der Polarisationsrichtung ein 90°-Spleiss (80) ist.

5. Stromsensor nach Anspruch 4, **dadurch gekennzeichnet, dass** der 90°-Spleiss (80) zwischen dem sensorseitigen Koppler (8) und dem Faserzweig (20) angeordnet ist.

6. Stromsensor nach Anspruch 1, **dadurch gekennzeichnet, dass** der Detektor (5) und eine die optischen Wellen erzeugende Lichtquelle (4) an einem gemeinsamen Ein- beziehungsweise Ausgang des detektorseitigen Kopplers (7) angeordnet sind.

7. Stromsensor nach Anspruch 6, **dadurch gekennzeichnet, dass** zwischen Lichtquelle (4) und detektorseitigem Koppler (7) ein dritter Koppler (7') angeordnet ist, und dass die Lichtquelle (4) und der Detektor (5) an verschiedenen Ein- beziehungsweise Ausgängen des dritten Kopplers (7') angeordnet sind.

8. Stromsensor nach Anspruch 1, **dadurch gekennzeichnet, dass** mehrere spulenförmige Sensorelemente (1,1') vorhanden sind und dass die faseroptische Zuleitung (2) weitere Faserzweige (23,24) aufweist, welche in Serie mit den erstgenannten Faserzweigen (20,21) angeordnet sind, wobei jedes spulenförmige Sensorelement (1,1') mit einem der weiteren Faserzweige (23,24) verbunden ist.

9. Stromsensor nach Anspruch 8, **dadurch gekennzeichnet, dass** die weiteren Faserzweige (23,24) unterschiedliche Länge aufweisen.

10. Stromsensor nach Anspruch 9, **dadurch gekennzeichnet, dass** die spulenförmigen Sensorelemente (1,1') eine unterschiedliche Anzahl von Faserwindungen aufweisen.

## Claims

1. Optical current sensor having a reflection interferometer which has a fibre-optic supply lead (2) and a coil-shaped optical sensor element (1), the sensor element (1) being connected with a first end to the fibre-optic supply lead (2) and being provided at a second, free end with a reflector (10), having at least one phase modulator (9) for modulating differential phases of two polarized waves propagating in the fibre-optic supply lead (2), and a detector (5), **characterized in that** the fibre-optic supply lead (2) has two fibre arms (20, 21) which interconnect a detector-side and a sensor-side coupler (7, 8), **in that** the at least one phase modulator (9) is arranged in one of these two fibre arms (20, 21), in which case it modulates the differential phase of two oppositely directed waves polarized parallel to one another, and **in that** one fibre arm (20) is provided with a means for changing the direction (80) of polarization such that optical waves with orthogonally linear polarizations propagate in a segment (22) of the supply lead fibre (2) adjoining the sensor-side coupler (8).

2. Current sensor according to Claim 1, **characterized in that** at least one fibre arm (20, 21) has a polarizer (25, 26) for producing a linear polarized optical wave.

3. Current sensor according to Claim 2, **characterized in that** both fibre arms (20, 21) have a polarizer (25, 26) for producing optical waves with linear polarizations directed parallel to one another.

4. Current sensor according to Claim 1, **characterized in that** the means for changing the direction of polarization is a 90° splice (80).

5. Current sensor according to Claim 4, **characterized in that** the 90° splice (80) is arranged between the sensor-side coupler (8) and the fibre arm (20).

6. Current sensor according to Claim 1, **characterized in that** the detector (5) and a light source (4) generating the optical waves are arranged at a common input or output of the detector-side coupler (7).

7. Current sensor according to Claim 6, **characterized in that** a third coupler (7') is arranged between the light source (4) and detector-side coupler (7), and **in that** the light source (4) and the detector (5) are arranged at different inputs and outputs of the third coupler (7').

8. Current sensor according to Claim 1, **characterized in that** a plurality of coil-shaped sensor elements (1, 1') are present, and **in that** the fibre-optic supply lead (2) has further fibre arms (23, 24) which are arranged in series with the first named fibre arms (20, 21), each coil-shaped sensor element (1, 1') being connected to one of the further fibre arms (23, 24).

9. Current sensor according to Claim 8, **characterized in that** the further fibre arms (23, 24) have different lengths.

10. Current sensor according to Claim 9, **characterized in that** the coil-shaped sensor elements (1, 1') have a different number of fibre turns.

## Revendications

1. Capteur de courant à fibre optique avec un interféromètre à réflexion, qui comprend une ligne d'arrivée à fibre optique (2) et un élément capteur optique en forme de bobine (1), l'élément capteur (1) étant raccordé par une première extrémité à la ligne d'arrivée à fibre optique (2) et étant pourvu à une deuxième extrémité libre d'un réflecteur (10), avec au moins un modulateur de phase (9) pour la modulation de phases différentielles de deux ondes polarisées se propageant dans la ligne d'arrivée à fibre optique (2) et avec un détecteur (5),
**caractérisé en ce que** la ligne d'arrivée à fibre optique (2) présente deux branches de fibre (20, 21) qui relient l'un à l'autre un coupleur du côté du détecteur et un coupleur du côté du capteur (7, 8), **en ce que** le au moins un modulateur de phase (9) est disposé dans une de ces deux branches de fibre (20, 21),
dans lequel il module la phase différentielle de deux ondes de sens contraire polarisées parallèlement l'une à l'autre, et **en ce qu'**une branche de fibre (20) est pourvue d'un moyen pour modifier la direction de polarisation (80), de telle façon que, dans un segment (22) de la fibre de la ligne d'arrivée (2) se raccordant au coupleur (8) du côté du capteur, se propagent des ondes optiques avec des polarisations linéaires orthogonales.

2. Capteur de courant selon la revendication 1, **caractérisé en ce qu'**au moins une branche de fibre (20, 21) présente un polarisateur (25, 26) pour produire une onde optique polarisée linéaire.

3. Capteur de courant selon la revendication 2, **caractérisé en ce que** les deux branches de fibre (20, 21) comportent un polarisateur (25, 26) pour la production d'ondes optiques avec des polarisations linéaires orientées parallèlement l'une à l'autre.

4. Capteur de courant selon la revendication 1, **caractérisé en ce que** le moyen pour modifier la direction de polarisation est une épissure à 90° (80).

5. Capteur de courant selon la revendication 4, **caractérisé en ce que** l'épissure à 90° (80) est disposée entre le coupleur du côté du capteur (8) et la branche de fibre (20).

6. Capteur de courant selon la revendication 1, **caractérisé en ce que** le détecteur (5) et une source de lumière (4) produisant les ondes optiques sont disposés à une entrée, respectivement à une sortie commune du coupleur du côté du détecteur (7).

7. Capteur de courant selon la revendication 6, **caractérisé en ce qu'**un troisième coupleur (7') est disposé entre la source de lumière (4) et le coupleur du côté du détecteur (7), et **en ce que** la source de lumière (4) et le détecteur (5) sont disposés à des entrées respectivement des sorties différentes du troisième coupleur (7').

8. Capteur de courant selon la revendication 1, **caractérisé en ce qu'**il est prévu plusieurs éléments capteurs en forme de bobines (1, 1') et **en ce que** la ligne d'arrivée à fibre optique (2) présente d'autres branches de fibre (23, 24), qui sont disposées en série avec les branches de fibre précitées (20, 21), chaque élément capteur en forme de bobine (1, 1') étant raccordé à une des autres branches de fibre (23, 24).

9. Capteur de courant selon la revendication 8, **caractérisé en ce que** les autres branches de fibre (23, 24) présentent une longueur différente.

10. Capteur de courant selon la revendication 9, **caractérisé en ce que** les éléments capteurs en forme de bobine (1, 1') présentent un nombre différent de spires de fibre.
